(19) Europäisches Patentamt
European Patent Office
Office européen des brevets

(11) EP 4 697 207 A1

(12) **EUROPEAN PATENT APPLICATION**
published in accordance with Art. 153(4) EPC

(43) Date of publication:
**18.02.2026 Bulletin 2026/08**

(51) International Patent Classification (IPC):
***G06F 17/15*** (2006.01)

(21) Application number: **24830019.6**

(22) Date of filing: **27.03.2024**

(52) Cooperative Patent Classification (CPC):
**G06F 7/523; G06F 17/15; G06N 3/063**

(86) International application number:
**PCT/CN2024/084221**

(87) International publication number:
**WO 2025/001367 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.06.2023 CN 202310798299**

(71) Applicant: **Huawei Technologies Co., Ltd.
Shenzhen, Guangdong 518129 (CN)**

(72) Inventors:
• **FAN, Tuanbao**
**Shenzhen, Guangdong 518129 (CN)**
• **JIANG, Yuexing**
**Shenzhen, Guangdong 518129 (CN)**
• **WANG, Yang**
**Shenzhen, Guangdong 518129 (CN)**
• **SHI, Xiaoshan**
**Shenzhen, Guangdong 518129 (CN)**
• **LIU, Yu**
**Shenzhen, Guangdong 518129 (CN)**
• **HU, Bo**
**Shenzhen, Guangdong 518129 (CN)**

(74) Representative: **Maiwald GmbH
Elisenhof
Elisenstraße 3
80335 München (DE)**

(54) **CONVOLUTION CIRCUIT, CONVOLUTION CALCULATION METHOD, CHIP AND ELECTRONIC DEVICE**

(57) Embodiments of this application provide a convolution circuit, a convolution computing method, a chip, and an electronic device, applied to the field of chip technologies, to resolve problems of high power consumption and a large wiring area of a convolution circuit in an existing convolver. The convolution circuit includes a plurality of multipliers, a first adder coupled to the plurality of multipliers, and a second adder coupled to the first adder. Each multiplier includes a plurality of precoders, a plurality of encoder groups, and an adder tree circuit. Each precoder is in a one-to-one correspondence with one encoder group. Output ends of the plurality of encoder groups and input lines of the adder tree circuit are of a same quantity and in a one-to-one correspondence. In addition, the adder tree circuit is coupled to the first adder. The second adder is further coupled to a memory. A partial product that is related only to a weight parameter may be first accumulated with a constant 1 in the multiplier, and then added to results output by adder tree circuits in the second adder, to reduce an area and power consumption of the adder tree circuit.

FIG. 10

## Description

This application claims priority to Chinese Patent Application No. 202310798299.9, filed with the China National Intellectual Property Administration on June 30, 2023 and entitled "CONVOLUTION CIRCUIT, CONVOLUTION COMPUTING METHOD, CHIP, AND ELECTRONIC DEVICE", which is incorporated herein by reference in its entirety.

## TECHNICAL FIELD

This application relates to the field of chip technologies, and in particular, to a convolution circuit, a convolution computing method, a chip, and an electronic device.

## BACKGROUND

With development of artificial intelligence (artificial intelligence, AI) technologies, an increasing quantity of artificial intelligence products enter people's lives. During implementation of the AI technology, the core of the AI technology includes two aspects: 1: an advanced neural network algorithm; and 2: a processor that provides massive hardware computing power. Computing of the neural network algorithm is mainly of a convolution computing type. Conventionally, there are two hardware solutions to implement convolution computing: (1) Convolution computing is equivalently converted into a matrix operation, and a general neural-network processing unit (neural-network processing unit, NPU) is designed to integrate a large quantity of multiplier matrices, to implement matrix multiplication calculation. (2) A dedicated convolver is designed to directly implement convolution computing. The first solution is a mainstream solution currently. However, in this solution, a large quantity of repeated read and write operations need to be performed on data, and consequently power consumption is increased. In the second solution, the convolver includes a plurality of multipliers and an adder. After the plurality of multipliers independently perform a multiplication operation on an input feature map, the adder performs accumulation to obtain an output feature map. However, structures of the multipliers are complex, and consequently power consumption and a wiring area of the convolver are increased.

## SUMMARY

Embodiments of this application provide a convolution circuit, a convolution computing method, a chip, and an electronic device, to resolve problems of high power consumption and a large wiring area of a current hardware circuit of a convolver.

To resolve the foregoing problem, embodiments of this application provide the following technical solutions.

According to a first aspect, a convolution circuit is provided. The convolution circuit includes a plurality of multipliers, a first adder, and a second adder. The multiplier includes a plurality of precoders, a plurality of encoder groups, and an adder tree circuit. The plurality of precoders are coupled to the plurality of encoder groups in a one-to-one correspondence. The adder tree circuit includes a plurality of input lines and a plurality of output lines. The plurality of encoder groups include a plurality of output ends. A quantity of the plurality of output ends is the same as a quantity of the plurality of input lines of the adder tree circuit, and the plurality of output ends of the plurality of encoder groups are coupled to the plurality of input lines of the adder tree circuit in a one-to-one correspondence. The adder tree circuit is coupled to the first adder through the plurality of output lines. The second adder includes a plurality of input ends and one output end. One of the plurality of input ends is configured to be coupled to a memory, and another input end of the plurality of input ends is configured to be coupled to the first adder. When a convolution operation is performed, the adder tree circuit only needs to perform the operation on data output by the plurality of encoder groups, and does not perform accumulation computation on a constant 1 and a partial product that is directly from an input and that is related to an odd bit of a weight parameter in the multiplier. This reduces a quantity of full-adders used in the adder tree circuit, and further reduces power consumption and a wiring area of the entire convolution circuit.

In a possible implementation, the plurality of precoders include a first precoder. The plurality of encoder groups include a first encoder group. The first precoder includes three input ends, a first logic circuit, and two output ends. The first encoder group includes a first input end and a second input end. The first input end of the first encoder group is coupled to a first input end of the first precoder through a first output end of the first precoder. The three input ends are further coupled to a second output end in the two output ends through the first logic circuit. The second input end of the first encoder group is coupled to the second output end in the two output ends. During convolution computing, the first encoder group further inputs a corresponding odd bit in the weight parameter. Two input ends of the first precoder input 2 bits before the odd bit. Based on this, the first input end of the first encoder group may directly input a $2^{nd}$ bit before the odd bit, and the second input end of the first encoder group inputs a value obtained through computing by the first logic circuit based on the 2 bits before the odd bit. Compared with a precoder in a conventional multiplier, the first precoder in this implementation can reduce one logical operation, so that power consumption is reduced and operation efficiency is improved.

In a possible implementation, the first logic circuit may perform an XNOR operation on signals input from a second input end and a third input end in the three input ends, then perform a NOR operation on an XNOR operation result and a signal input from the first input end in the three input ends, and output an operation result from the second output end in the two output ends. Based on this, compared with a conventional precoder, the first precoder may perform one less XOR operation, so that operation power consumption is further reduced.

In a possible implementation, the first logic circuit includes an XNOR gate and a NOR gate. A first input end of the NOR gate is coupled to an output end of the XNOR gate. A second input end of the NOR gate is coupled to the first input end of the first precoder. A first input end of the XNOR gate is coupled to the second input end of the first precoder. A second input end of the XNOR gate is coupled to the third input end of the first precoder. An output end of the NOR gate is coupled to the second output end of the first precoder. Based on this, compared with a conventional precoder, the first precoder may be provided with one less XOR gate, so that a wiring area of the convolution circuit is further reduced.

In a possible implementation, the convolution circuit further includes a register circuit. The plurality of precoders and the plurality of encoder groups are further coupled to the register circuit. Parameters required in an operation process of the precoder and the plurality of encoder groups may be cached through the register circuit.

In a possible implementation, the memory is configured to store a computing constant, and the computing constant is determined based on the weight parameter. Based on this, a corresponding computing constant may be computed in advance based on the weight parameter and stored in the memory. During convolution computing, the computing constant may be directly transmitted to the second adder, to reduce a computing amount of a convolution operation, improve operation efficiency, reduce a circuit area, and reduce power consumption.

In a possible implementation, the computing constant is a result obtained by accumulating an odd bit of a weight parameter of an input feature map and a constant 1 on a corresponding digit.

According to a second aspect, a convolution computing method applied to the convolution circuit in the first aspect is provided. An execution procedure of the convolution computing method includes: first, receiving a plurality of input feature maps and a weight parameter and a computing constant that are pre-specified for each input feature map, where the computing constant is determined based on the weight parameter; then, transmitting one input feature map and one weight parameter to each multiplier, and performing an operation through the plurality of precoders, the plurality of encoder groups, and the adder tree circuit that are in the multiplier to obtain a corresponding operation result; then, accumulating operation results of the multipliers through the first adder to obtain first data; and finally, transmitting the computing constant to the second adder, and adding the first data and the computing constant through the second adder to obtain an output feature map.

In a possible implementation, the computing constant may be a result of accumulating an odd bit of the weight parameter of the input feature map and a constant 1 on a corresponding digit.

In a possible implementation, performing the operation through the plurality of precoders, the plurality of encoder groups, and the adder tree circuit that are in the multiplier to obtain the corresponding operation result includes: first, outputting, by each precoder, two precoded signals based on two corresponding bits in the weight parameter; then, outputting, by each encoder in an encoder group corresponding to the precoder, a corresponding partial product based on the two precoded signals and a corresponding odd bit in the weight parameter; and finally, performing, by the adder tree circuit, a carry addition operation on partial products output by a plurality of encoder groups to obtain the operation result.

According to a third aspect, a computer-readable storage medium is provided. The computer-readable storage medium stores computer program instructions. When the computer program instructions are executed by a processor, the convolution computing method according to the second aspect is implemented.

According to a fourth aspect, a chip is provided. The chip includes a circuit board and the convolution circuit according to any one of the possible implementations of the first aspect disposed on the circuit board.

According to a fifth aspect, an electronic device is provided. The electronic device includes a memory and the chip according to the fourth aspect coupled to the memory.

According to a sixth aspect, a computer program product is provided. When the computer program product is executed by a processor, the convolution computing method according to the second aspect is implemented.

For technical effects brought by the second aspect to the sixth aspect and the possible implementations, refer to the technical effect descriptions of the first aspect and the possible implementations. Details are not described herein again.

**BRIEF DESCRIPTION OF DRAWINGS**

FIG. 1 is a block diagram of a structure of an electronic device according to an embodiment of this application;
FIG. 2 is a principle diagram of convolution computing based on a matrix multiplication operation;
FIG. 3 is a principle diagram of a convolution operation performed based on a convolver;

FIG. 4 is a diagram of a convolution computing process;

FIG. 5 is a block diagram of a hardware structure of a convolver;

FIG. 6 is a block diagram of a composition structure of a multiplication circuit;

FIG. 7 is a diagram of an internal structure of a multiplier;

FIG. 8 is a diagram of a structure of a precoder in a multiplier;

FIG. 9 is a principle diagram of an adder tree circuit in a multiplier;

FIG. 10 is a principle diagram of a convolution circuit according to an embodiment of this application;

FIG. 11 is a principle diagram of an adder tree circuit according to an embodiment of this application;

FIG. 12 is a diagram of a structure of a first precoder according to an embodiment of this application;

FIG. 13 is a diagram of a structure of a second precoder according to an embodiment of this application;

FIG. 14 is a diagram of a structure of an encoder according to an embodiment of this application;

FIG. 15 is a diagram of a structure of a multiplier according to an embodiment of this application;

FIG. 16 is a schematic flowchart of a convolution method according to an embodiment of this application;

FIG. 17 is a diagram of a structure of a chip according to an embodiment of this application; and

FIG. 18 is a diagram of a structure of another chip according to an embodiment of this application.

## DESCRIPTION OF EMBODIMENTS

The following describes the technical solutions in embodiments of this application with reference to the accompanying drawings in embodiments of this application.

To clearly describe the technical solutions in embodiments of this application, terms such as "first" and "second" are used in embodiments of this application to distinguish between same items or similar items that have basically the same functions and purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to give an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

When some embodiments are described, expressions of "coupling" and "connection" and their extensions may be used. For example, when some embodiments are described, the term "connection" may indicate that two or more components are in direct physical contact or point contact with each other. For another example, when some embodiments are described, the term "coupling" may indicate that two or more components are in direct physical contact or electrical contact with each other, or may indicate that two or more components are not in direct contact with each other, but still cooperate with or interact with each other. Embodiments disclosed herein are not necessarily limited to content of this specification.

The following describes this application in detail with reference to the accompanying drawings and embodiments.

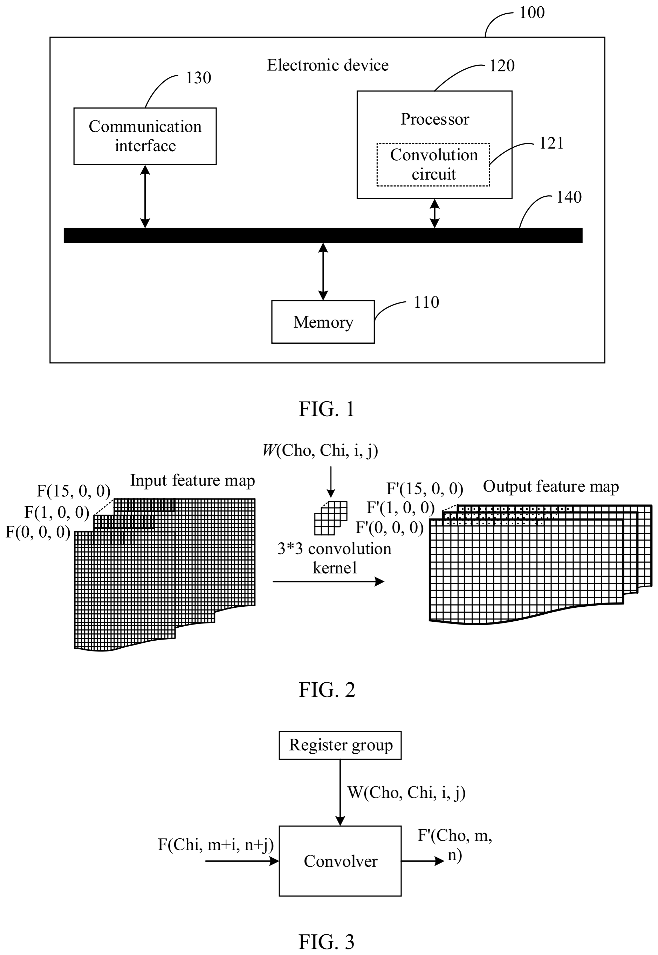

Currently, AI technologies are used in many electronic devices 100. The electronic device 100 may be a terminal, a server, or the like, or may be a chip, a chip set, a circuit board, a module, or the like in a terminal or a server. As shown in FIG. 1, the electronic device 100 may include a memory 110, a processor 120, a communication interface 130, and a bus 140. The memory 110, the processor 120, and the communication interface 130 are connected to each other through the bus 140. The memory 110 may be configured to store data, a software program, and a module, and mainly includes a program storage area and a data storage area. The program storage area may store an operating system, an application program required for at least one function, and the like. The data storage area may store data created during use of the device, and the like. The processor 120 is configured to: control and manage an action of the communication device, for example, perform various functions and data processing of the device by running or executing a software program and/or module stored in the memory 110 and invoking data stored in the memory 110. The communication interface 130 is configured to support communication of the device.

The processor 120 includes but is not limited to a central processing unit (central processing unit, CPU), a network processing unit (network processing unit, NPU), a graphics processing unit (graphics processing unit, GPU), a digital signal processor (digital Signal processor, DSP), a general-purpose processor, or the like. The processor 120 may include a convolution circuit 121. The convolution circuit 121 includes one or more multipliers, for example, includes a multiplier array. The multiplier is a device that implements a multiplication operation in the processor. In addition, the convolution circuit 121 may alternatively be disposed on a circuit board and used as an independent chip, and perform a convolution operation based on received data.

The bus 140 may be a peripheral component interconnect (peripheral component interconnect, PCI) bus, an extended industry standard architecture (extended industry standard architecture, EISA) bus, or the like. Buses 140 may be classified into an address bus, a data bus, a control bus, and the like. For ease of denotation, the bus 140 is indicated by using only one bold line in FIG. 1, but this does not mean that there is only one bus or only one type of bus.

The memory 110 may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which is used as an external cache. By way of example rather than limitation, many forms of random access memories (random access memories, RAMs) may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

In the electronic device 100, the core of the AI technology is mainly reflected in two aspects: an advanced neural network algorithm, and a processor that can provide massive hardware computing power. The neural network algorithm needs to perform a large amount of convolution computing, and a formula of a convolution operation is as follows:

$$F'\big(Cho, m, n\big) = \sum_{Chi=0}^{Chi=C-1} \sum_{i=0}^{i=Kw-1} \sum_{j=0}^{j=Kh-1} F\big(Chi, m + i, n + j\big) * W\big(Cho, Chi, i, j\big)$$

$F(Chi, m+i, n+j)$ indicates an input feature map; $W(Cho, Chi, i, j)$ indicates a weight parameter; $F'(Cho, m, n)$ indicates an output feature map; Kw indicates a length of a convolution kernel; Kh indicates a width of the convolution kernel; C indicates a quantity of input channels; Chi indicates an input channel; Cho indicates an output channel; and m and n indicate coordinates corresponding to the output feature map.

To implement the foregoing convolution computing, the following two hardware solutions are usually used. One is to equivalently convert convolution computing into a matrix operation, and a general neural-network processing unit (neural-network processing unit, NPU) is designed to integrate a large quantity of multiplier matrices, to implement matrix multiplication calculation. The other is to design a dedicated convolver to directly implement convolution computing. When matrix multiplication calculation is implemented through the general neural-network processing unit, first, input feature maps (feature maps) of C input channels needs to be replicated by Kw*Kh times through an image to column (image to column, im2col for short) transformation, then, the input feature maps of the C input channels are partitioned into C*P small matrices, a matrix multiplication operation is separately performed on the C*P small matrices by using a convolution kernel (kernel) to generate output feature map matrices, and finally, the Kw*Kh output feature map matrices are added to obtain a convolution operation result corresponding to the input feature maps. Herein, P indicates a quantity of matrices that can be obtained by partitioning each input feature map. For example, a matrix multiplication operation is performed by using a 3*3 convolution kernel. In this case, Kw=3 and Kh=3. When Chi=16, P=16, C=16, m=0, n=0 to 16, and Cho=16, a convolution computing formula of each output feature map $F'(Cho, 0, n)$ is as follows:

$$F'\big(Cho, 0, n\big) = \sum_{Chi=0}^{Chi=15} \sum_{i=0}^{i=2} \sum_{j=0}^{j=2} F\big(Chi, m + i, n + j\big) * W\big(Cho, Chi, i, j\big)$$

A process of performing a matrix multiplication operation on an input feature map of each input channel by using a convolution kernel is shown in FIG. 2, and a corresponding principle is as follows:

$$F'(Cho, 0, n) = \sum_{\substack{i=0 \\ j=0}}^{\substack{i=2 \\ j=2}} \begin{bmatrix} F(0, i, 0+j) & F(1, i, 0+j) & ... & F(15, i, 0+j) \\ F(0, i, 0+j) & F(1, i, 0+j) & ... & F(15, i, 0+j) \\ ... & F(1, i, 0+j) & ... & F(15, i, 0+j) \\ F(0, i, 0+j) & F(1, i, 0+j) & ... & F(15, i, 0+j) \end{bmatrix} \times$$

$$\begin{bmatrix} W(0, 0, i, j) & W(1, 0, i, j) & ... & W(15, 0, i, j) \\ W(0, 1, i, j) & W(1, 1, i, j) & ... & W(15, 1, i, j) \\ ... & ... & ... & ... \\ W(0, 15, i, j) & W(1, 15, i, j) & ... & W(15, 15, i, j) \end{bmatrix}$$

$$= \begin{bmatrix} F'(0, 0, 0) & F'(1, 0, 0) & ... & F'(15, 0, 0) \\ F'(0, 0, 1) & F'(1, 0, 1) & ... & F'(15, 0, 1) \\ ... & ... & ... & ... \\ F'(0,0,15) & F'(1,0,15) & ... & F'(15,0,15) \end{bmatrix}$$

In the foregoing implementation process, more read and write time needs to be consumed for data due to a plurality of im2col transformation processes. This increases power consumption.

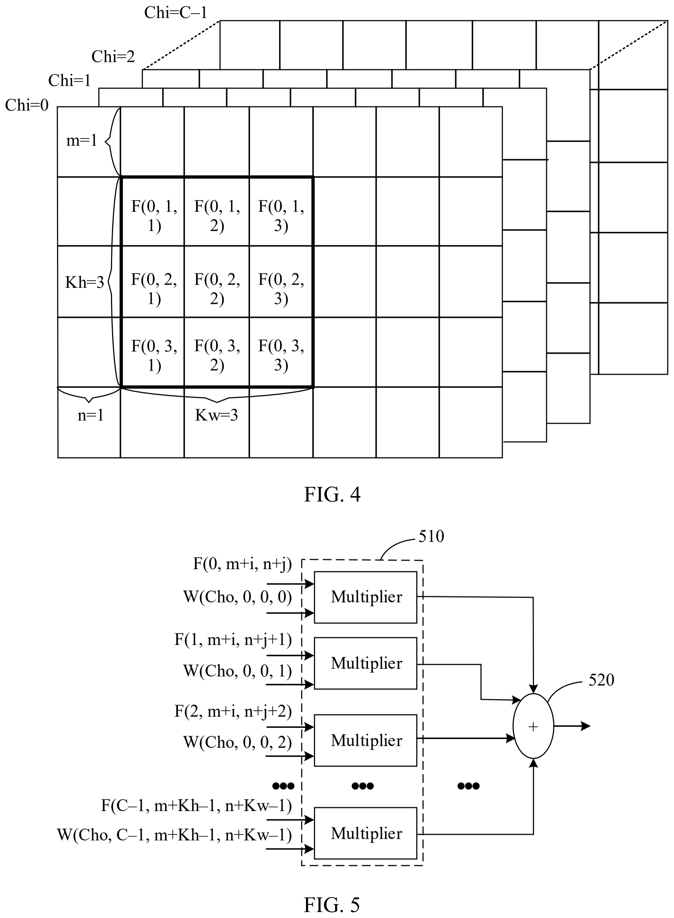

In addition, an implementation in which convolution computing is implemented through a dedicated convolver is shown in FIG. 3. The convolver may perform convolution computing on a multi-channel feature map F (Chi, m+i, n+j) input based on a weight parameter W (Cho, Chi, i, j) stored in a register group, and output a corresponding feature map F' (Cho, m, n). For example, as shown in FIG. 4, the convolver may start performing convolution, by using a 3*3 convolution kernel (that is, Kw=3 and Kh=3), from a first row and a first column (that is, m=1 and n=1) of the input multi-channel feature map, then perform convolution with a stride of one pixel, ..., and perform convolution until a last row and a last column.

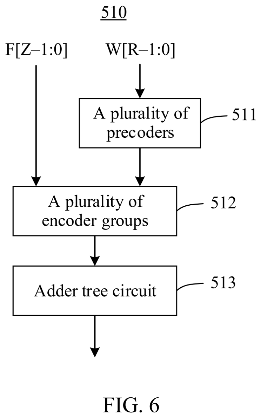

To implement convolution computing, as shown in FIG. 5, a convolution circuit inside the convolver usually includes a plurality of multipliers 510 and an adder 520 coupled to the plurality of multipliers 510. Each multiplier 510 may independently perform a multiplication operation on one feature map and a weight parameter, and then input an operation result into the adder 520 for addition, to obtain a final output result. As shown in FIG. 6, the multiplier 510 includes a plurality of precoders 511, a plurality of encoder groups 512, and an adder tree circuit 513. First, the plurality of precoders 511 may precode 3 bits specified in a weight parameter corresponding to an input feature map on which convolution is currently performed. Then, each encoder group 512 may perform encoding based on two pieces of encoded data output by a corresponding precoder 511 and each bit in the input feature map, and output a corresponding operation result after the adder tree circuit 513 performs a carry addition operation. The operation result may be accumulated with an operation result output by another multiplier through the adder 520, to obtain a final output feature map. W[R-1:0] indicates a $0^{th}$ bit W [0] in the weight parameter to an $(R-1)^{th}$ bit W[R-1] in the weight parameter. R is usually an even number, and indicates a total quantity of bits in the weight parameter. F[Z-1:0] indicates a $0^{th}$ bit F[0] to a $(Z-1)^{th}$ bit F[Z-1] in the input feature map, and Z is a total quantity of bits in the input feature map. R and Z may be the same or different.

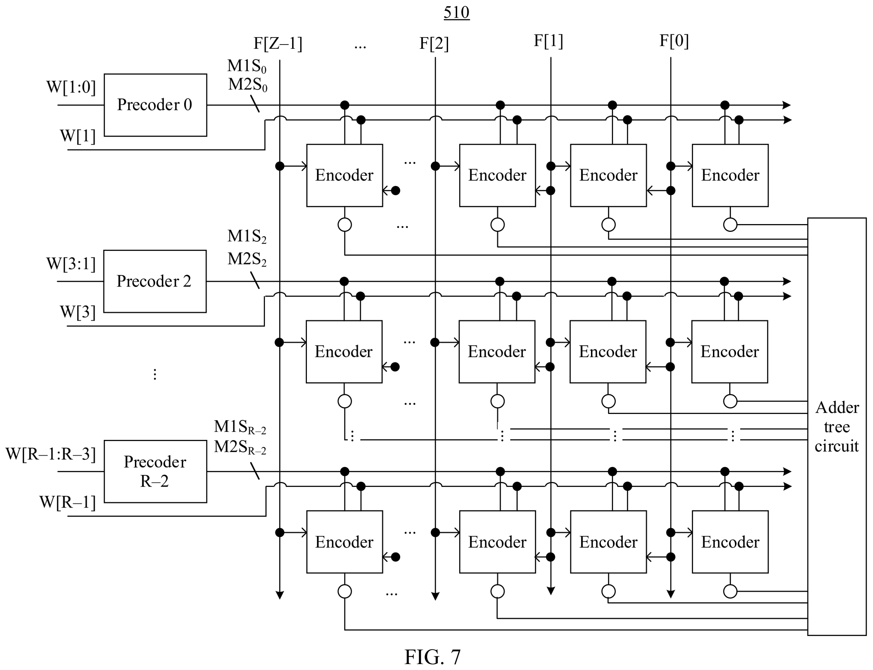

As shown in FIG. 7, a plurality of feature input lines and a plurality of weight input lines are usually disposed in the multiplier 510. A quantity of feature input lines and a quantity of encoders in each encoder group are the same as a quantity of bits (bits) in a feature map, and a quantity of precoders and a quantity of weight input lines are half of the quantity of feature input lines. For example, if an int8 feature map includes 8-bit data, a quantity of feature input lines is 8, a quantity of encoders is 8, and a quantity of precoders and a quantity of weight input lines are both 4. Each feature input line is used to input one bit in the feature map. In each encoder group, except that a $1^{st}$ encoder is coupled only to a feature input line corresponding to the $0^{th}$ bit F[0], other encoders are sequentially coupled to feature input lines corresponding to two adjacent bits. For example, a $2^{nd}$ encoder in the encoder group may be coupled to the feature input line corresponding to the $0^{th}$ bit F[0] and a feature input line corresponding to the $1^{st}$ bit F[1] (denoted as F[0]&F[1]). A $3^{rd}$ encoder in the encoder group may be coupled to the feature input line corresponding to the $1^{st}$ bit F[1] and a feature input line corresponding to the $2^{nd}$ bit F[2]. The same applies to other encoders. Details are not described herein in this application. In addition, each encoder group is further coupled to a corresponding weight input line. Each precoder may provide two precoded signals (M1S and M2S) for an encoder based on 2 bits specified in a weight parameter. Two precoded signals output by each precoder in FIG. 7 are distinguished by using even numbers in subscripts 0 to (R-2). Further, each encoder in each encoder group performs, based on the corresponding two precoded signals and an input value of the corresponding weight input line, an operation on values of 2 bits input by two feature input lines, to obtain a corresponding partial product. The partial product is output after the adder tree circuit performs a carry addition operation. An input of each weight input line is an odd bit in a weight parameter corresponding to the input feature map. For example, in a weight parameter corresponding to an R-bit feature map, values of bits are sequentially W[0], W[1], ..., and W[R-1]. In this case, values output by weight input lines in a corresponding multiplier are respectively W[1], W[3], W[5], ..., and W[R-1]. An input of each feature input line is a value of one bit (one of F[0] to F[Z-1]) in the input feature map.

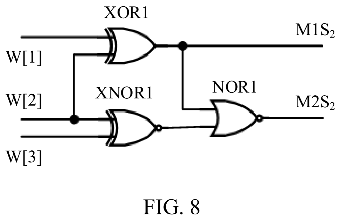

As shown in FIG. 8, in a plurality of precoders, a part of the precoders each include an XOR gate XOR1, an XNOR gate XNOR1, and a NOR gate NOR1. For example, if an input value of a weight input line corresponding to an encoder group is a value W[3] of a $3^{rd}$ bit in a weight parameter, a value input from a first input end of an XNOR gate XNOR1 of a corresponding precoder is W[3]. A value input from a second input end of the XNOR gate XNOR1 is W[2]. In addition, a value input from a first input end of a corresponding XOR gate XOR1 is W[1]. A second input end of the XOR gate XOR1 is coupled to the second input end of the corresponding XNOR gate XNOR1. A first input end of a NOR gate NOR1 and a first encoding input end of the corresponding encoder group are both coupled to an output end of the XOR gate XOR1. A second input end of the NOR gate NOR1 is coupled to an output end of the XNOR gate XNOR1. An output end of the NOR gate NOR1 is coupled to a second encoding input end of the corresponding encoder group. Further, structures of subsequent precoders are the same as a structure of the precoder corresponding to the encoder group into which W[3] is input. Details are not described herein in embodiments of this application.

In the foregoing convolution circuit, the adder tree circuit may perform an addition operation based on a coupling relationship between each encoder and both a weight input line and a feature input line. For example, each encoder group may be considered as one row, and encoders in the encoder groups may be considered as one column. A column in which each encoder in each encoder group is located corresponds to a digit ($2^0$ to $2^n$) in a partial product output by the adder tree circuit. The digit may also be referred to as a weight bit. When performing an operation, the adder tree circuit may perform a carry addition operation on outputs of encoders at a same digit. Starting from a second row, an output of an encoder in a $k^{th}$ column ($k \geq 1$) in each row and an output of an encoder in a $(k+2)^{th}$ column in a previous row are binary bits at a same weight bit. In addition, when an addition operation is performed on outputs of encoders corresponding to a $1^{st}$ column in a $1^{st}$ row to a $1^{st}$ column in a last row, a partial product S related to the weight parameter further needs to be added to an end of each odd column. The partial product S may be a value of an odd bit of the weight parameter. When an addition operation is performed on outputs of encoders corresponding to a last column in the $1^{st}$ row to a last column in the last row, a constant 1 further needs to be added to each odd column.

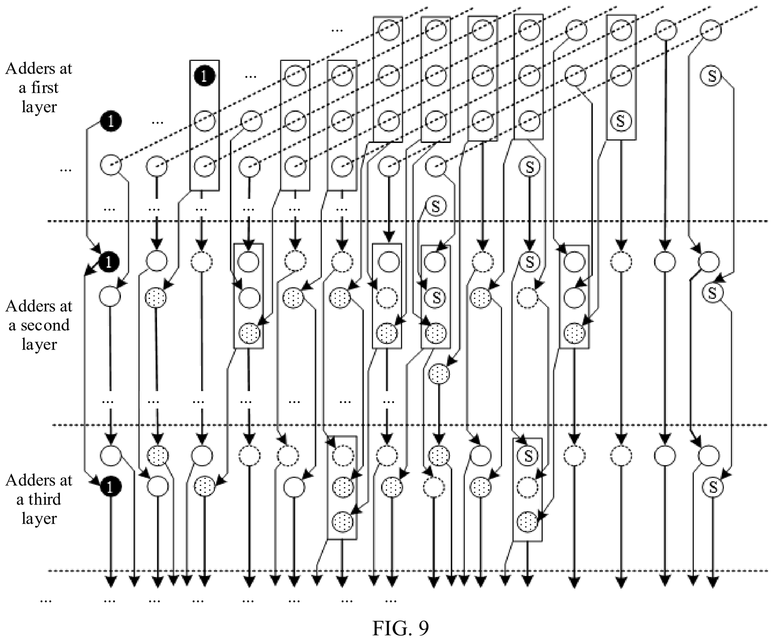

To implement the foregoing addition operation, as shown in FIG. 9, the foregoing adder tree circuit usually uses a multi-layer adder structure. In addition to an output of the encoder group, an input of the adder tree circuit further includes the partial product S and the constant 1. Each layer of the adder tree circuit performs parallel addition on binary bits (for example, columns in FIG. 9) at a same weight bit through a plurality of full-adders (small rectangular frames in FIG. 9). Each adder inputs a 3-bit binary number, and outputs one sum bit (for example, a dashed circle in FIG. 9) and one carry bit (for example, a dotted circle in FIG. 9). The sum bits output by all adders and remaining bits that are not added at a current layer are transmitted to a vertical column of a same weight bit at a second layer in the adder tree, and carry bits of the adders are transmitted to a vertical column of an adjacent higher weight bit at the second layer, to form a second layer arrangement array. Adders at the second layer perform parallel addition on binary bits at a same weight bit, sum bits output by all adders and remaining bits that are not added at the current layer are transmitted to a vertical column of a same weight bit at a third layer in the adder tree, carry bits of the adders at the second layer are transmitted to a vertical column of an adjacent higher weight bit at the third layer, ..., and parallel addition is performed until the last layer. When only data of no more than 2 bits is left in the vertical column of each weight bit, parallel addition is completed.

It can be learned from the foregoing content that although convolution computing can be implemented through the foregoing multiplier, in addition to performing a carry addition operation on outputs of encoders, an adder tree circuit inside each multiplier further needs to perform an operation on the partial product S and the constant 1. Therefore, a large quantity of full-adders need to be disposed. This increases a wiring area and power consumption.

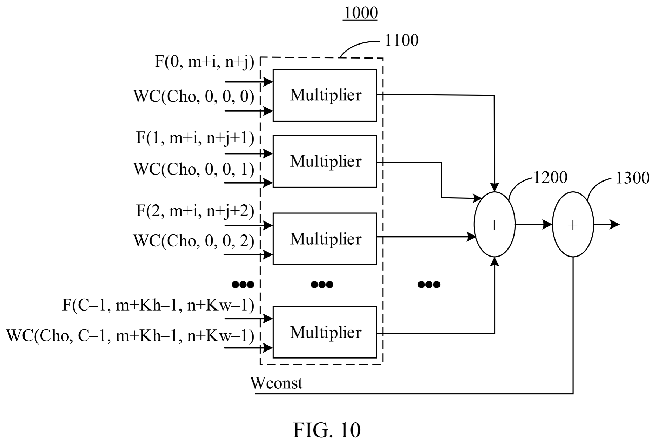

It is considered that when convolution computing is performed on an input feature map, a convolution kernel including weight parameters remains unchanged in an entire convolution process. Therefore, this feature may be used to simplify a hardware convolution circuit, to reduce an area and power consumption of the convolution circuit. Therefore, to resolve the foregoing problem, as shown in FIG. 10, an embodiment of this application provides a convolution circuit 1000. The convolution circuit 1000 includes a plurality of multipliers 1100, a first adder 1200, and a second adder 1300. The first adder 1200 is coupled to the plurality of multipliers 1100. The second adder 1300 is coupled to the first adder 1200. Each multiplier 1100 includes a plurality of precoders, a plurality of encoder groups, and an adder tree circuit. The plurality of precoders are coupled to the plurality of encoder groups in a one-to-one correspondence. The adder tree circuit includes a plurality of input lines and a plurality of output lines. The plurality of encoder groups include a plurality of output ends. A quantity of output ends of the plurality of encoder groups is the same as a quantity of the plurality of input lines, and the plurality of output ends are coupled to the plurality of input lines in a one-to-one correspondence. The adder tree circuit is coupled to the first adder through the plurality of output lines. The second adder is further coupled to a memory. The memory is configured to store a computing constant. The computing constant may be determined based on a weight parameter. For example, the computing constant may be a result of accumulating an odd bit of a weight parameter of an input feature map and a constant 1 on a corresponding digit.

When the convolution operation is performed through the convolution circuit 1000, the adder tree circuit may perform an addition operation on data output by the plurality of encoder groups. The first adder 1200 may add outputs of multipliers and then transmit a sum to the second adder 1300. Further, after a partial product S related to the weight parameter of the input feature map is added to the constant 1, the sum may be transmitted to the second adder 1300 as a computing constant Wconst. After the second adder 1300 adds the computing constant to an output of the first adder 1200, a corresponding output feature map may be obtained. Based on this, an operation amount of the adder tree circuit can be reduced, so that a quantity of full-adders used by the adder tree circuit is reduced, and power consumption and a wiring area of the convolution circuit 1000 are reduced.

In the convolution circuit 1000, a quantity of multipliers may be adjusted based on a size of a convolution kernel. For example, if the size of the convolution kernel is 3*3, the quantity of multipliers is 9, and each multiplier may compute one of feature maps corresponding to nine pixels in a convolution range. If the size of the convolution kernel is 4*4, the quantity of multipliers is 16, and each multiplier may compute one of feature maps corresponding to 16 pixels in the convolution range.

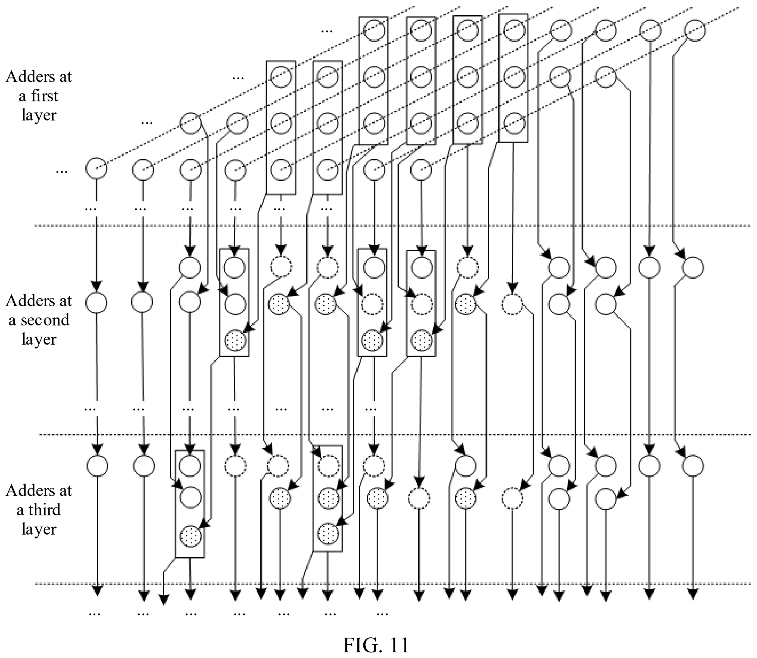

In a possible implementation solution, a structure of the adder tree circuit provided in embodiments of this application is shown in FIG. 11. The adder tree circuit also performs parallel addition on binary bits (for example, columns in FIG. 11) that are at a same weight bit and that are output by the encoder group through a plurality of full-adders (rectangular small boxes in FIG. 11). However, an input of the adder tree circuit provided in embodiments of this application includes only an output of the encoder group. When performing an addition operation, each adder also inputs a 3-bit binary number, and outputs one sum bit (for example, a dashed circle in FIG. 11) and one carry bit (for example, a dotted circle in FIG. 11). The sum bits output by all adders and remaining bits that are not added at a current layer are transmitted to a vertical column of a same weight bit at a second layer in the adder tree, and carry bits of the adders are transmitted to a vertical column of an adjacent higher weight bit at the second layer, to form a second layer arrangement array. Adders at the second layer perform parallel addition on binary bits at a same weight bit, sum bits output by all adders and remaining bits that are not added at the current layer are transmitted to a vertical column of a same weight bit at a third layer in the adder tree, carry bits of the adders at the second layer are transmitted to a vertical column of an adjacent higher weight bit at the third layer, ..., and parallel addition is performed until the last layer. When only data of no more than 2 bits is left in the vertical column of each weight bit, parallel addition is completed. Because an input of the adder tree circuit includes only an output of the encoder group, a quantity of full-adders used at each layer of the adder tree circuit is less than that of a conventional adder tree circuit. This reduces a wiring area and power consumption of the adder tree circuit.

Further, in an implementation solution, the plurality of multipliers may share one adder tree circuit. A quantity of input lines in the adder tree circuit is a sum of quantities of encoders in all the multipliers. Refer to FIG. 11. In the adder tree circuit, binary bits that are at a same weight bit and that are output by encoder groups in the multipliers may be added in parallel, and adders are disposed by layer with reference to a manner in FIG. 11.

In the foregoing manner, outputs of the plurality of multipliers may be directly added while an adder tree circuit does not need to be independently disposed in each multiplier, and a first adder does not need to be disposed. This further improves operation efficiency.

In a possible implementation solution, the plurality of precoders include a first precoder. The plurality of encoder groups include a first encoder group. The first precoder may be used as any precoder other than a precoder 0 in FIG. 7. The first precoder includes three input ends, a first logic circuit, and two output ends. The first encoder group includes a first input end and a second input end. The first input end of the first encoder group is coupled to a first input end in the three input ends through a first output end in the two output ends. The three input ends are further coupled to a second output end in the two output ends through the first logic circuit. The second input end of the first encoder group is coupled to the second output end in the two output ends. The first logic circuit is configured to: perform an XNOR operation on signals input from a second input end and a third input end in the three input ends, then perform a NOR operation on an XNOR operation result and a signal input from the first input end in the three input ends, and output an operation result from the second output end in the two output ends.

In the foregoing manner, when the multiplier performs an operation on an input feature map, the first precoder in each multiplier only needs to perform the XNOR operation and the NOR operation on weight parameters input from the three input ends. This reduces operation power consumption.

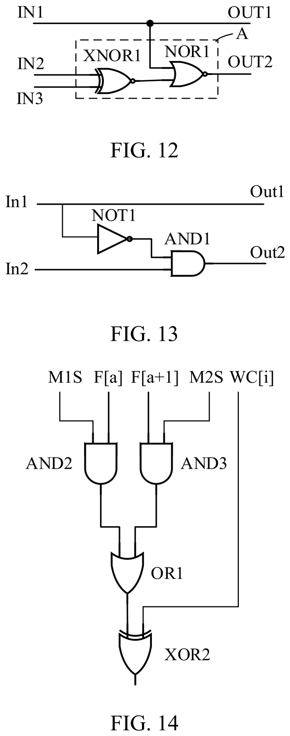

For example, as shown in FIG. 12, the first logic circuit A in the first precoder includes an XNOR gate XNOR1 and a NOR gate NOR1. A first input end of the NOR gate NOR1 is coupled to an output end of the XNOR gate XNOR1. A second input end of the NOR gate NOR1 is coupled to a first input end IN1 of the first precoder. A first input end of the XNOR gate XNOR1 is coupled to a second input end IN2 of the first precoder. A second input end of the XNOR gate XNOR1 is coupled to a third input end IN3 of the first precoder. The first input end IN1 of the first precoder is coupled to a first output end OUT1 of the first precoder. An output end of the NOR gate NOR1 is coupled to a second output end OUT2 of the first precoder.

According to the foregoing structure, compared with the conventional precoder in FIG. 8, the first precoder in this embodiment of this application can reduce one XOR gate. The convolution circuit 1000 usually includes a plurality of multipliers. Therefore, the foregoing first precoder can be used to reduce a logic operation amount and reduce a wiring area.

Further, the plurality of precoders further include a second precoder. The plurality of encoder groups further include a second encoder group. The second precoder may be used as a precoder 0 in FIG. 7. The second precoder includes two input ends, a second logic circuit, and two output ends. The second encoder group includes a first input end and a second input end. A first input end in the two input ends of the second precoder is coupled to the first input end in the second encoder group through a first output end in the two output ends. The two input ends are further coupled to a second output end in the two output ends through the second logic circuit. The second logic circuit may perform phase inversion on a signal that is input from the first input end in the two input ends, then perform an AND logical operation on a signal obtained through phase inversion and a signal input from the second input end, and output an operation result from the second output end in the two output ends.

In a possible implementation solution, as shown in FIG. 13, the second precoder includes a first AND gate AND1 and a NOT gate NOT1. An input end of the NOT gate NOT1 is coupled to a first input end In1 of the second precoder. An output end of the NOT gate NOT1 is coupled to a first input end of the first AND gate AND1. A second input end of the first AND gate AND1 is coupled to a second input end In2 of the second encoder. A first output end out1 of the second precoder is coupled to a first input end in1 of the second precoder. An output end of the first AND gate AND1 is coupled to a second output end out2 of the second precoder. The input end of the NOT gate NOT1 may input a value of a $0^{th}$ bit in a weight parameter corresponding to a feature map. The second input end of the first AND gate AND1 may input a value of a $1^{st}$ bit in the weight parameter corresponding to the feature map.

In another implementation solution, the NOT gate NOT1 of the second precoder may be alternatively disposed between the first input end and the first output end of the second precoder, and the first input end of the first AND gate AND1 is directly coupled to the first input end of the second precoder. In this case, the input end of the NOT gate NOT1 may input a value obtained by negating the value of the $0^{th}$ bit in the weight parameter corresponding to the feature map.

In an implementation solution, the first encoder group and the second encoder group each include a plurality of encoders. As shown in FIG. 14, each encoder includes a second AND gate AND2, a third AND gate AND3, a first OR gate OR1, and a first XOR gate XOR2. A first input end of the second AND gate AND2 is configured to input first encoded data M1S output by a corresponding precoder. A second input end of the second AND gate AND2 is configured to input a value F[a] of an $a^{th}$ bit in the feature map. A first input end of the third AND gate AND3 is configured to input second encoded data M2S output by a corresponding precoder. An input of a second input end of the third AND gate AND3 is a value F[a-1] of an $(a-1)^{th}$ bit in the input feature map. Herein, a is an integer not less than 1. In addition, if a = 0, both the second input end of the second AND gate AND2 and the second input end of the third AND gate AND3 input a value F[0] of a $0^{th}$ bit in the input feature map. The first input end of the first OR gate OR1 is coupled to an output end of the second AND gate AND2. The second input end of the first OR gate OR1 is coupled to an output end of the third AND gate AND3. The first input end of the first XOR gate XOR2 is coupled to an output end of the first OR gate OR1. The second input end of the first XOR gate XOR2 is configured to input a value WC[i] of an odd bit in the weight parameter. Herein, i is an odd number between 0 and R.

In the foregoing implementation process, data of each bit in the feature map and the weight parameter may be transmitted to a corresponding component through a register circuit. The register circuit may be coupled to a memory, and the register circuit includes a plurality of registers. Each weight parameter and a value of each bit in the input feature map may be cached through an independent register. In addition, when the first precoder and the second precoder need to input a same weight parameter, the first precoder and the second precoder may be coupled to a same register. When encoders in each encoder group need to input values of a same bit in the feature map, the encoders in each encoder group may also be coupled to a same register. Based on this, a quantity of components can be reduced and a wiring area can be reduced while it is ensured that the multiplier performs operations in an orderly manner.

Further, when the first precoder and a conventional precoder are used in the multiplier, a quantity of first precoders may be set according to an actual requirement.

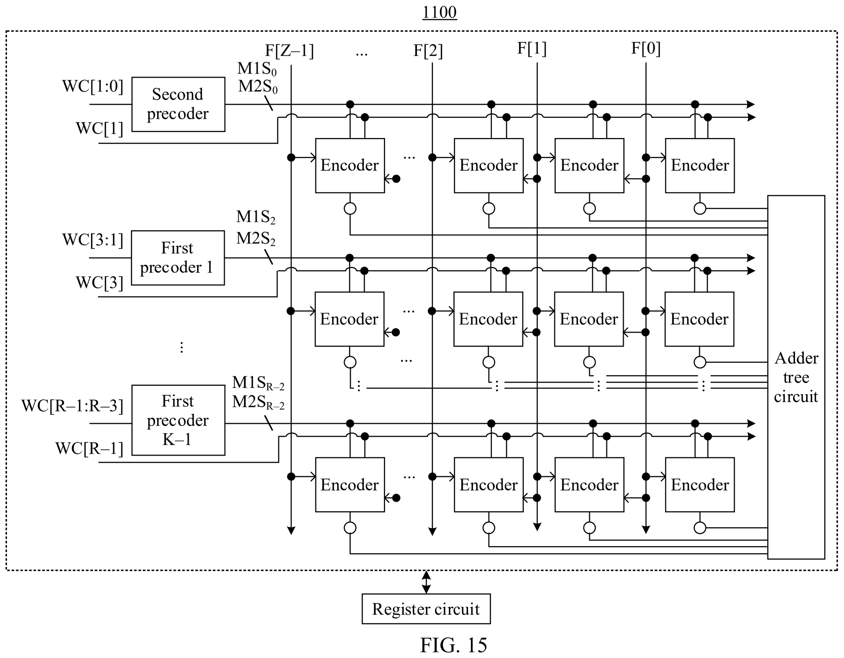

For example, in an implementation solution, as shown in FIG. 15, the multiplier may include K-1 first precoders and one second precoder, where K indicates a total quantity of precoders in the multiplier. Each first precoder and the second precoder are coupled to a corresponding encoder group. A first input end of the second precoder is configured to input a value WC[0] of a $0^{th}$ bit in the weight parameter. A second input end of the second precoder is configured to input a value WC[1] of a $1^{st}$ bit in the weight parameter. A value of a corresponding odd bit after WC[1] in the weight parameter may be input from a third input end of each first precoder. A value input to each weight input line is the same as a value input from the third input end of the corresponding first precoder. A second input end of the first precoder inputs a value of a $1^{st}$ bit before a corresponding odd bit. A second input end of the first precoder inputs a value of a $2^{nd}$ bit before a corresponding odd bit. For example, if a value WC[3] of a $3^{rd}$ bit in the weight parameter is input from a third input end of the first precoder, a value WC[2] of a $2^{nd}$ bit in the weight parameter is input from the second input end of the first precoder, and the value WC[1] of the $1^{st}$ bit in the weight parameter is input from the first input end of the first precoder. A conversion relationship between a value of each bit of a weight parameter in the multiplier provided in this embodiment of this application and a value of each bit of a weight parameter in a conventional multiplier is as follows:

$$WC[i] = \begin{cases} W[i], & i = 0 \text{ or is an odd number} \\ XNOR(W[i-1], W[i]), & i \text{ an even number} \end{cases},$$

where XNOR represents an XNOR operation. For a conversion relationship between values of bits in the weight parameter, refer to Table 1.

Table 1

| Weight parameters in this application | Conventional weight parameters |
|---|---|
| WC[0] | W[0] |
| WC[1] | W[1] |
| WC[2] | W[1] XNOR W[2] |
| WC[3] | W[3] |
| WC[4] | W[3] XNOR W[4] |
| WC[5] | W[5] |
| WC[6] | W[5] XNOR W[6] |
| WC[7] | W[7] |

In Table 1, W[i] represents a value of each bit in a weight parameter of a conventional multiplier. WC[i] represents a value of each bit in a weight parameter of a multiplier provided in this embodiment of this application. WC[i] may be precomputed based on the conversion relationship in Table 1 and then stored in a memory. When a convolution operation needs to be performed, WC[i] may be cached through a register coupled to the memory, and then transmitted to the conventional precoder and each first precoder.

In the foregoing implementation process, a quantity of first precoders used in the multiplier may be adjusted according to an actual requirement, and is not limited to the quantity in the foregoing implementation solution.

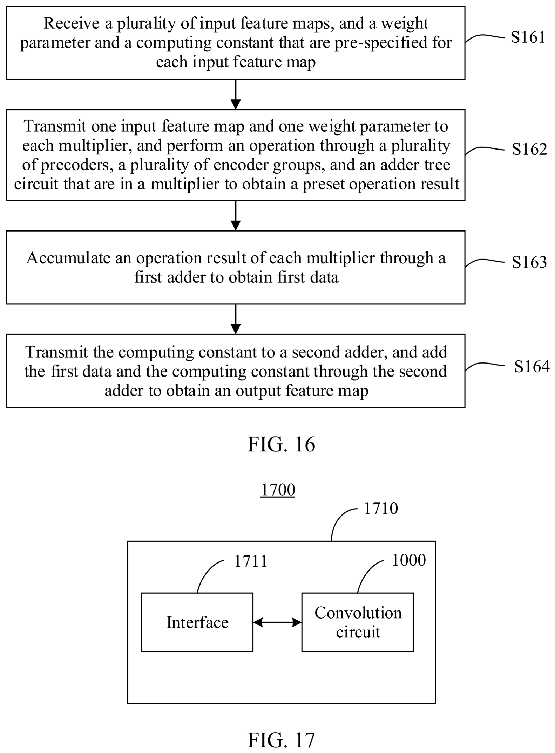

In an implementation solution, as shown in FIG. 16, an embodiment of this application further provides a convolution computing method applied to the convolution circuit. An execution process of the convolution computing method is as follows:

S161: Receive a plurality of input feature maps, and a weight parameter and a computing constant that are pre-specified for each input feature map.

The computing constant is a constant obtained after an odd bit in the weight parameter of the input feature map and a constant 1 are accumulated. The weight parameter corresponding to each input feature map includes a value of each bit in the feature map. During convolution computing, the odd bit of the weight parameter and the constant 1 are both pre-configured known parameters, and the two fixed parameters also need to be added to data finally output by a convolver. Therefore, the two parameters may be accumulated as a pre-configured computing constant, and computation does not need to be performed through an adder tree circuit. Each input feature map, the weight parameter, and the computing constant may be stored in a memory. The weight parameter and the computing constant that are pre-specified for each input feature map may be pre-stored in the memory. When convolution computing needs to be performed, a value of each bit of the weight parameter, a value of each bit of the input feature map, and the computing constant may be read into a corresponding register in a register circuit.

S162: Transmit one input feature map and one weight parameter to each multiplier, and perform operation through a plurality of precoders, a plurality of encoder groups, and the adder tree circuit that are in the multiplier, to obtain a corresponding operation result.

In each convolution process, a value of a pixel at a location in an input feature map of each multiplier is used. When the foregoing steps are performed, a quantity of bits of the weight parameter may be the same as a quantity of bits of the input feature map. For example, if the input feature map is int8 data, during a convolution operation, a weight parameter input to each multiplier may include values of 8 bits. Each precoder may first output two precoded signals based on values of two corresponding bits in the weight parameter. Then, an encoder group corresponding to each precoder outputs a plurality of partial products based on the two precoded signals and a value of a corresponding odd bit in the weight parameter. Finally, the adder tree circuit performs a carry addition operation on partial products output by a plurality of encoder groups to obtain the operation result.

In the foregoing implementation process, the quantity of bits of the weight parameter may be different from the quantity of bits of the input feature map. A specific case may be set according to an actual convolution operation requirement.

S163: Accumulate an operation result of each multiplier through a first adder to obtain first data.

S164: Transmit the computing constant to a second adder, and add the first data and the computing constant through the second adder to obtain an output feature map.

In a convolution computing process, the computing constant is a result of accumulating the odd bit of the weight parameter of the input feature map and the constant 1 on a corresponding digit. The computing constant may be cached through the register, to ensure that a corresponding operation process can be performed in a more orderly manner in a high-speed operation environment.

In a possible implementation, an embodiment of this application further provides a computer-readable storage medium. The computer storage medium may store computer program instructions. When the computer program instructions are executed by a processor, the foregoing convolution computing method may be implemented. The processor may be a central processing unit (central processing unit, CPU), a general-purpose processor, a network processor (network processor, NP), a digital signal processor (digital signal processor, DSP), a microprocessor unit (microcontroller unit, MCU), a microcontroller, a programmable logic device (programmable logic device, PLD), or any combination thereof. The processor may alternatively be another apparatus having a processing function, for example, a circuit, a component, or a software module. This is not limited in this application. The computer-readable storage medium may be a read-only memory (read-only memory, ROM), a random access memory (random access memory, RAM), a compact disc read-only memory (compact disc read-only memory, CD-ROM), a magnetic tape, a floppy disk, a USB flash drive, an optical data storage device, or the like.

In a possible implementation, an embodiment of this application further provides a chip. The chip includes a circuit board and the convolution circuit 1000 disposed on the circuit board. The circuit board may be a printed circuit board (printed circuit board, PCB) or a substrate (including but not limited to a silicon substrate). In an example, as shown in FIG. 17, the chip may be sold or used as an independent convolution chip 1700. An interface 1711 coupled to the convolution circuit 1000 may be disposed on the circuit board 1710. The convolution circuit 1000 may receive, through the interface 1711, an input feature map sent by an external device (for example, a processor), and output a processed output feature map to the external device. Certainly, the convolution chip may alternatively be disposed on the circuit board together with one or more processors as a chip system for sale or use. This is not specifically limited in this embodiment of this application.

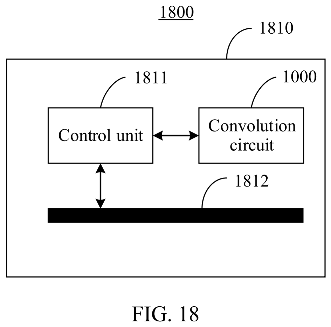

In another example, as shown in FIG. 18, the chip may alternatively be a processor 1800. The processor 1800 includes a control unit 1811 and a convolution circuit 1000 that are disposed on a circuit board 1810. The convolution circuit 1000 may be coupled to the control unit 1811, and the control unit 1811 may receive an input feature map through a bus 1812. Then, the input feature map is sent to the convolution circuit 1000 for a convolution operation, to obtain a corresponding output feature map. Finally, the output feature map is sent to a next-level processing unit in the processor 1800 through the control unit 1811, or is sent to another device through the bus 1812 for processing. Certainly, the convolution circuit 1000 may alternatively be coupled to the control unit 1811 through the bus 1812. This is not specifically limited in this embodiment of this application.

In the foregoing implementation process, the processor may be a central processing unit (central processing unit, CPU), a general-purpose processor, a network processor (network processor, NP), a field programmable gate array (field programmable gate array, FPGA), an application-specific integrated circuit (application-specific integrated circuit, ASIC), a system on chip (system on chip, SoC), or any combination thereof. This is not specifically limited in this embodiment of this application.

Further, in the foregoing implementation process, the chip in the foregoing two examples may alternatively include another type of component. This is not specifically limited in embodiments of this application.

A person of ordinary skill in the art may be aware that functions of circuits in examples described with reference to embodiments disclosed in this specification can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

In the several embodiments provided in this application, it should be understood that the disclosed circuit and electronic device may be implemented in other manners. For example, the described device embodiments are merely examples. For example, division into the modules is merely logical function division, and may be other division in actual implementation. For example, a plurality of modules or components may be combined or may be integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

In addition, the chip in embodiments of this application may be integrated into one device, or each of the modules may exist alone physically, or two or more modules are integrated into one device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A convolution circuit, comprising a plurality of multipliers, a first adder coupled to the plurality of multipliers, and a second adder coupled to the first adder, wherein

the multiplier comprises a plurality of precoders, a plurality of encoder groups, and an adder tree circuit; and the plurality of precoders are coupled to the plurality of encoder groups in a one-to-one correspondence; the adder tree circuit comprises a plurality of input lines and a plurality of output lines; the plurality of encoder groups comprise a plurality of output ends; a quantity of the plurality of output ends is the same as a quantity of the plurality of input lines, and the plurality of output ends are coupled to the plurality of input lines in a one-to-one correspondence; and the adder tree circuit is coupled to the first adder through the plurality of output lines; and the second adder comprises a plurality of input ends and one output end, one of the plurality of input ends is configured to be coupled to a memory, and another input end in the plurality of input ends is configured to be coupled to the first adder.

2. The convolution circuit according to claim 1, wherein the plurality of precoders comprise a first precoder; and the plurality of encoder groups comprise a first encoder group; and
the first precoder comprises three input ends, a first logic circuit, and two output ends; the first encoder group comprises a first input end and a second input end; the first input end of the first encoder group is coupled to a first input end in the three input ends through a first output end in the two output ends; the three input ends are further coupled to a second output end in the two output ends through the first logic circuit; and the second input end of the first encoder group is coupled to the second output end in the two output ends.

3. The convolution circuit according to claim 2, wherein
the first logic circuit is configured to: perform an XNOR operation on signals input from a second input end and a third input end in the three input ends, then perform a NOR operation on an XNOR operation result and a signal input from the first input end in the three input ends, and output an operation result from the second output end in the two output ends.

4. The convolution circuit according to claim 2 or 3, wherein the first logic circuit comprises an XNOR gate and a NOR gate;

a first input end of the NOR gate is coupled to an output end of the XNOR gate; and a second input end of the NOR gate is coupled to the first input end of the first precoder;
a first input end of the XNOR gate is coupled to the second input end of the first precoder; and a second input end of the XNOR gate is coupled to the third input end of the first precoder; and
an output end of the NOR gate is coupled to the second output end of the first precoder.

5. The convolution circuit according to any one of claims 1 to 3, further comprising a register circuit, wherein the plurality of precoders and the plurality of encoder groups are further coupled to the register circuit.

6. The convolution circuit according to any one of claims 1 to 5, wherein the memory is configured to store a computing constant; and the computing constant is determined based on a weight parameter.

7. The convolution circuit according to claim 6, wherein the computing constant is a result of accumulating an odd bit of a weight parameter of an input feature map and a constant 1 on a corresponding digit.

8. A convolution computing method, applied to a convolution circuit, wherein the convolution circuit comprises a plurality of multipliers, a first adder coupled to the plurality of multipliers, and a second adder coupled to the first adder; the multiplier comprises a plurality of precoders, a plurality of encoder groups, and an adder tree circuit; the plurality of precoders are coupled to the plurality of encoder groups in a one-to-one correspondence; the adder tree circuit comprises a plurality of input lines and a plurality of output lines; the plurality of encoder groups comprise a plurality of output ends; a quantity of the plurality of output ends is the same as a quantity of the plurality of input lines, and the plurality of output ends are coupled to the plurality of input lines in a one-to-one correspondence; the adder tree circuit is coupled to the first adder through the plurality of output lines; the second adder comprises a plurality of input ends and one output end, and one of the plurality of input ends is configured to be coupled to a memory; and the method comprises:

receiving a plurality of input feature maps and a weight parameter and a computing constant that are pre-specified for each input feature map, wherein the computing constant is determined based on the weight parameter; transmitting one input feature map and one weight parameter to each multiplier, and performing an operation through the plurality of precoders, the plurality of encoder groups, and the adder tree circuit that are in the multiplier to obtain a corresponding operation result; accumulating operation results of the multipliers through the first adder to obtain first data; and transmitting the computing constant to the second adder, and adding the first data and the computing constant through the second adder to obtain an output feature map.

9. The method according to claim 8, wherein the computing constant is a result of accumulating an odd bit of the weight parameter of the input feature map and a constant 1 on a corresponding digit.

10. The method according to claim 8, wherein performing the operation through the plurality of precoders, the plurality of encoder groups, and the adder tree circuit that are in the multiplier to obtain the corresponding operation result comprises:

outputting, by each precoder, two precoded signals based on two corresponding bits in the weight parameter; outputting, by an encoder group corresponding to each precoder, a plurality of partial products based on the two precoded signals and a corresponding odd bit in the weight parameter; and performing, by the adder tree circuit, a carry addition operation on the plurality of partial products to obtain the operation result.

11. A computer-readable storage medium, storing computer program instructions, wherein when the computer program instructions are executed by a processor, the method according to any one of claims 8 to 10 is implemented.

12. A chip, comprising a circuit board and the convolution circuit according to any one of claims 1 to 7 disposed on the circuit board.

13. An electronic device, comprising a memory and the chip according to claim 12 coupled to the memory.

100

Electronic device

130

Communication interface

120

Processor

Convolution circuit

121

140

110

Memory

FIG. 1

$W(Cho, Chi, i, j)$

F(15, 0, 0)    Input feature map

F(1, 0, 0)

F(0, 0, 0)

3*3 convolution kernel

F'(15, 0, 0)    Output feature map

F'(1, 0, 0)

F'(0, 0, 0)

FIG. 2

Register group

$W(Cho, Chi, i, j)$

$F(Chi, m+i, n+j)$

Convolver

$F'(Cho, m, n)$

FIG. 3

Chi=C−1

Chi=2

Chi=1

Chi=0

m=1

| F(0, 1, 1) | F(0, 1, 2) | F(0, 1, 3) |
| F(0, 2, 1) | F(0, 2, 2) | F(0, 2, 3) |
| F(0, 3, 1) | F(0, 3, 2) | F(0, 3, 3) |

Kh=3

n=1      Kw=3

FIG. 4

510

F(0, m+i, n+j)
W(Cho, 0, 0, 0)
Multiplier

F(1, m+i, n+j+1)
W(Cho, 0, 0, 1)
Multiplier

F(2, m+i, n+j+2)
W(Cho, 0, 0, 2)
Multiplier

●●●        ●●●        ●●●

F(C−1, m+Kh−1, n+Kw−1)
W(Cho, C−1, m+Kh−1, n+Kw−1)
Multiplier

520
+

FIG. 5

510

F[Z−1:0]          W[R−1:0]

A plurality of precoders — 511

A plurality of encoder groups — 512

Adder tree circuit — 513

FIG. 6

FIG. 7

FIG. 8

FIG. 9

EP 4 697 207 A1

FIG. 10

Adders at a first layer

Adders at a second layer

Adders at a third layer

FIG. 11

IN1            OUT1

IN2    XNOR1    NOR1    OUT2

IN3

A

## FIG. 12

In1            Out1

NOT1    AND1

In2            Out2

## FIG. 13

M1S   F[a]   F[a+1]   M2S   WC[i]

AND2        AND3

OR1

XOR2

## FIG. 14

FIG. 15

EP 4 697 207 A1

| Receive a plurality of input feature maps, and a weight parameter and a computing constant that are pre-specified for each input feature map | S161 |

| Transmit one input feature map and one weight parameter to each multiplier, and perform an operation through a plurality of precoders, a plurality of encoder groups, and an adder tree circuit that are in a multiplier to obtain a preset operation result | S162 |

| Accumulate an operation result of each multiplier through a first adder to obtain first data | S163 |

| Transmit the computing constant to a second adder, and add the first data and the computing constant through the second adder to obtain an output feature map | S164 |

FIG. 16

1700

1710

1711 1000

| Interface | ⟷ | Convolution circuit |

FIG. 17

1800

1810

1811

1000

Control unit ↔ Convolution circuit

1812

FIG. 18

## INTERNATIONAL SEARCH REPORT

| International application No. |
|---|
| **PCT/CN2024/084221** |

**A. CLASSIFICATION OF SUBJECT MATTER**

G06F 17/15(2006.01)i

According to International Patent Classification (IPC) or to both national classification and IPC

**B. FIELDS SEARCHED**

Minimum documentation searched (classification system followed by classification symbols)

IPC:G06F

Documentation searched other than minimum documentation to the extent that such documents are included in the fields searched

Electronic data base consulted during the international search (name of data base and, where practicable, search terms used)

CNABS; CNTXT; VEN; WOTXT; EPTXT; CNKI; USTXT; IEEE: 卷积, 乘法器, 加法器, 加法树, 常数, 部分积, convolution, multiplier, adder, adder tree, constant, partial product

**C. DOCUMENTS CONSIDERED TO BE RELEVANT**

| Category* | Citation of document, with indication, where appropriate, of the relevant passages | Relevant to claim No. |
|---|---|---|
| Y | WANG, Yang et al. "Dual-Side Sparse Tensor Core" *2021 ACM/IEEE 48th Annual International Symposium on Computer Architecture (ISCA)*, 04 August 2021 (2021-08-04), ISSN: 2575-713X, pages 1083-1095 | 1-2, 5-13 |
| Y | CN 115956231 A (HUAWEI TECHNOLOGIES CO., LTD.) 11 April 2023 (2023-04-11) description, paragraphs 44-65 | 1-2, 5-13 |
| Y | CN 113767362 A (HUAWEI TECHNOLOGIES CO., LTD.) 07 December 2021 (2021-12-07) description, paragraphs 61-82 | 1-2, 5-13 |
| A | US 2021384891 A1 (INTEL CORP.) 09 December 2021 (2021-12-09) entire document | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 June 2024** | **15 June 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

International application No.

**PCT/CN2024/084221**

| Patent document cited in search report | | | Publication date (day/month/year) | Patent family member(s) | | | Publication date (day/month/year) |
|---|---|---|---|---|---|---|---|
| CN | 115956231 | A | 11 April 2023 | WO | 2023015442 | A1 | 16 February 2023 |
| | | | | EP | 4336346 | A1 | 13 March 2024 |
| CN | 113767362 | A | 07 December 2021 | WO | 2021196096 | A1 | 07 October 2021 |
| | | | | EP | 4080350 | A1 | 26 October 2022 |
| | | | | US | 2022374205 | A1 | 24 November 2022 |
| | | | | EP | 4080350 | A4 | 28 December 2022 |
| US | 2021384891 | A1 | 09 December 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310798299